# EUROPEAN PATENT SPECIFICATION

(11) **EP 3 171 409 B1**
(45) Date of publication and mention of the grant of the patent: **30.12.2020**
(21) Application number: 15195235.5
(22) Date of filing: 18.11.2015
(51) Int. Cl.: H01L 29/417, H01L 29/66, H01L 29/78

(54) **METHOD FOR FORMING A FIELD EFFECT TRANSISTOR DEVICE HAVING AN ELECTRICAL CONTACT**
VERFAHREN ZUR HERSTELLUNG EINER FELDEFFEKTTRANSISTORVORRICHTUNG MIT EINEM ELEKTRISCHEN KONTAKT
PROCÉDÉ DE FORMATION D'UN DISPOSITIF DE TRANSISTOR À EFFET DE CHAMP AYANT UN CONTACT ÉLECTRIQUE

(43) Date of publication of application: 24.05.2017
(73) Proprietor: IMEC VZW, 3001 Leuven (BE)
(72) Inventor: Demuynck, Steven, 3001 Leuven (BE); Tao, Zheng, 3001 Leuven (BE); Chan, Boon Teik, 3001 Leuven (BE); Witters, Liesbeth, 3001 Leuven (BE); Schaekers, Marc, 3001 Leuven (BE); Peter, Antony Premkumar, 3001 Leuven (BE); Armini, Silvia, 3001 Leuven (BE)
(74) Representative: Patent Department IMEC

(56) References cited:
- KR-A- 20100 107 228
- US-A1- 2013 065 371
- US-A1- 2014 191 314
- US-A1- 2014 312 395
- US-A1- 2015 137 194
- US-A1- 2015 137 271
- US-A1- 2015 235 897
- US-A1- 2015 294 863
- US-B1- 6 524 952

## Description

### Technical field of the invention

The present invention is related to the formation of a field effect transistor device having an electrical contact. The application is for fin-type field effect transistor devices.

### Background of the invention

As the transistor sizes are reducing in pursuit of Moore's law, increase in series resistance towards the channel is becoming a challenge. This is due to the fact that the performance of the device, such as for example, sub-threshold slope (SS), drain induced barrier lowering (DIBL) and drain saturation current (I_{Dsat}) can adversely be influenced if the series resistance is not minimized. This has to do mainly with the increase in contact resistance, which is one of the main components of the series resistance.

Contact resistance is a function of the resistance of (1)contact metal fill, (2)interface metal/semiconductor resistivity and (3)contact area.
1. Resistance of the fill metal is depending on whether the material needs to be integrated with contact liners and what the contribution of these contact liners is to the overall resistance.
2. Metal/semiconductor resistivity is a function of the number of active dopants at the interface and the choice of interface metal. In pursuit of Moore's Law, alternative material choices are introduced instead of silicon, such as strained silicon (s-Si), strained germanium (s-Ge) SiGe, or III-V compound semiconductor materials, to form the channel of a field effect transistor (FET)

In this respect, the choice of interface metal may depend on the type of material in the source and drain (S/D) region of the FET, which is chosen among the aforementioned alternative materials to be integrated for nMOS and pMOS, respectively. Additionally, the formation and thermal stability of the electrical contact as a function of the choice of the interface metal also plays a role.

Additionally, with the device scaling in pursuit of Moore's Law, introduction of new FET designs such as fin-type FET (finFET) or Tri-gate FET has taken place. Thus, there is a trend to integrate taller fin structures at tighter pitch to maximize drive current per footprint (accelerated by fin depopulation considerations). This leads to reduction in the contact area, which in turns leads to an increase in contact resistance. Besides, in relation with the influence of contact area, contact opening is also critical since the damage on the S/D region of the FET within the contact area is typically created during contact opening. Damage to the S/D region risks altering the number of active dopants, which in turn influences the aforementioned metal/semiconductor resistivity thus, resulting in an increase in contact resistance.

There is, therefore, a need in the art for a method that can enable the formation of an electrical contact on or completely surrounding the source region and drain region of a FET without resulting in damage to the substrate in the source/drain region; thus leading to an electrical contact having minimized contact resistance. The document US20150137194 discloses a known method for the fabrication of source and drain contacts on a FinFET device.

### Summary of the invention

It is an object of the present invention to provide good methods for fabricating a semiconductor structure.

It is an advantage of embodiments of the present invention that the method allows fabricating a semiconductor structure that has an undamaged source region or drain region.

It is an advantage of embodiments of the present invention that the method allows producing a semiconductor structure suitable for fabricating FETs particularly requiring doping concentration of at least 1x10²⁰/cm³ in the source region or drain region.

It is an advantage of embodiments of the present invention that the method allows forming an electrical contact with reduced contact resistance on source region or drain region thanks to the undamaged source region or drain region.

It is an advantage of embodiments of the present invention that the method allows forming an electrical contact, which is conformal and contacts the entire source region or drain region such that the electrical contact is formed not only at the top but also laterally on the side of the source region or drain region.

It is an advantage of embodiments of the present invention that the method allows carrying out the high-k last replacement metal gate (HKL-RMG) module after contact hole opening and electrical contact formation therein. This diminishes the problem of damaging the alignment markers. Damaging the alignment markers may typically occur when HKL-RMG is carried out before opening the contact hole and forming the electrical contact.

The above objective is accomplished by a method according to the present invention, which is defined in the appended claims.

In a first aspect, the present invention relates to a method for fabricating a semiconductor structure. The method comprises providing a patterned substrate comprising a semiconductor region and a dielectric region. Directly on the patterned substrate a conformal layer of a first dielectric material is deposited. The deposited conformal layer of a first dielectric material, thereby covers the semiconductor region and the dielectric region. A layer of a sacrificial material is deposited on the conformal layer of the first dielectric material. The sacrificial material is patterned, whereby at least a part of the semiconductor region remains uncovered by the patterned sacrificial material. A layer of a second dielectric material is deposited on the patterned substrate that completely covers the patterned sacrificial material. An excess portion of the second dielectric material is removed by performing a surface flattening process, thereby exposing a top surface of the patterned sacrificial material. A recess is formed in the second dielectric material by completely removing the patterned sacrificial material selectively to the conformal layer. Complete removal of the patterned sacrificial material exposes the conformal layer of the first dielectric material at the bottom of the recess. The exposed conformal layer of the first dielectric material is removed selectively to the semiconductor region. This selective removal at least exposes the part of the semiconductor region.

In embodiments, patterning the sacrificial material may comprise providing a patterned photoresist layer on the sacrificial material. The patterned photoresist layer may be defined by photoresist features separated by apertures, whereby the apertures expose the sacrificial material. The sacrificial material is dry plasma etched using the patterned photoresist layer as mask. After completion of the dry plasma etching, patterned photoresist layer is removed by performing a photoresist strip process.

In embodiments, removing the exposed conformal layer of the first dielectric material selectively to the semiconductor region may be done by performing a wet etching process.

In embodiments, removing the exposed conformal layer of the first dielectric material selectively to the semiconductor region may also be done by subjecting the semiconductor structure to a vapor treatment.

In embodiments of the present invention, removal of the exposed conformal layer of the first dielectric material by performing the wet etching process or the vapor treatment is advantageous since it avoids creating damages on the semiconductor region from which it is removed.

In embodiments, the sacrificial material may be an amorphous carbon material or an amorphous silicon material.

It is an advantage according to embodiments of the present invention that the amorphous carbon material or the amorphous silicon material has good etch selectivity with respect to the first dielectric material.

In embodiments, the depositing of the conformal layer of the first dielectric material may be done by Atomic Layer Deposition (ALD) .

It is an advantage according to embodiments of the present invention that ALD provides a conformal layer of the first dielectric material on the patterned substrate. Furthermore, thickness of the first dielectric material deposited by ALD may be in the range of 1 nm to 10 nm, preferably in the range of 1 nm to 5 nm.

In embodiments, the exposed part of the semiconductor region may be a part of a source region or of a drain region of a field effect transistor (FET).

In embodiments, the present invention relates to a method for forming an electrical contact to a semiconductor structure. The method comprises providing a semiconductor structure fabricated according to any embodiments of the present invention.

In embodiments, the semiconductor structure may comprise a patterned substrate. The patterned substrate may comprise a semiconductor region and a dielectric region. A layer of a second dielectric material may be overlaying on the patterned substrate. The second dielectric material has a recess that exposes a part of the semiconductor structure.

In embodiments, the exposed part of the semiconductor structure may be a part of the semiconductor region.

In embodiments, the exposed part of the semiconductor region may be a part of a source region or a drain region of a field effect transistor (FET).

In embodiments, the field effect transistor may be a fin-type field effect transistor (finFET). The finFET may comprise structures having lateral walls and a top surface that protrude from the dielectric material. These protruding structures are fin structures.

In embodiments, the semiconductor structure may further comprise a conformal layer of a first dielectric material present on an un-exposed part of the semiconductor structure. The un-exposed part of the semiconductor structure is overlaid by the second dielectric material.

A self-assembled monolayer (SAM) material is selectively applied on the second dielectric material and on an exposed part of the dielectric region of the semiconductor structure, whereby the exposed part of the semiconductor region remains uncovered. The electrical contact is formed on the exposed part of the semiconductor region at the bottom of the recess. Preferably, the electrical contact may be a conformal electrical contact. SAM material is selectively removed from the semiconductor structure.

It is an advantage of embodiments of the present invention that selective application of the SAM material allows the formation of the electrical contact selectively on the exposed semiconductor region, which is not covered by the SAM material. This is advantageous since it removes the need for carrying out an additional chemical mechanical planarization step, which would otherwise be required to remove the metal from the field areas that are outside the recess.

In embodiments, forming the electrical contact may further comprise depositing a contact metal overlaying the semiconductor structure filling in the recess. The contact metal is a contact metal fill.

In embodiments, forming the electrical contact may comprise depositing selectively a metal on the exposed part of the semiconductor region at the bottom of the recess. A vapor-solid reaction is performed, whereby the semiconductor structure is subjected to a silicon-comprising precursor gas or a germanium comprising precursor gas thereby converting the metal to respectively a metal silicide or a metal germanide.

It is an advantage according to embodiments of the present invention that the formation of the electrical contact does not depend on the materials choice of the exposed semiconductor region, on which the metal is deposited.

It is also an advantage according to embodiments of the present invention that it allows the formation of the electrical contact without consuming the material of the exposed semiconductor region thanks to the vapor-solid reaction.

In embodiments, forming the electrical contact may also comprise depositing a layer stack by using an ALD process. The layer stack may comprise a metal layer in contact with the exposed part of the semiconductor region at the bottom of the recess and a metal nitride layer on and in contact with the metal layer.

In embodiments, the metal may be titanium (Ti). Ti is advantageous due to the fact that it is a good oxygen getter.

In embodiments, the metal nitride may be titanium nitride (TiN) . TiN is advantageous due to the fact that it forms a good interface between Ti and the contact metal.

In embodiments, the electrical contact may be a wrap-around contact.

It is an advantage according to embodiments of the present invention that the wrap-around contact allows for contacting the exposed semiconductor region from all sides. Contacting the exposed semiconductor region from all sides maximizes the contact area, thereby minimizing contact resistance.

### Brief description of the figures

Fig. 1 is a schematic (a) cross section and, (b) and (c) tilted view of a patterned substrate comprising on a main surface a semiconductor region and a dielectric region.
Fig. 2 (a) to Fig. 2(h) show schematically fabricating a semiconductor structure according to embodiments of the present invention.
Fig. 3 is a cross section Transmission Electron Microscopy (TEM) image and (b) schematic representation of a semiconductor structure after formation of the recess.
Fig. 4 shows a tilted view of a semiconductor structure fabricated according to embodiments of the present invention.
Fig. 5 (a) to Fig. 5(e) show schematically the formation of an electrical contact to a semiconductor structure according to embodiments of the present invention.

### Detailed description of the invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

It is to be noticed that the term "*comprising*", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof.

Reference throughout the specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout the specification are not necessarily all referring to the same embodiment, but may. Furthermore, the particular features, structures or characteristics may be combined in any suitable manner, as would be apparent to one of ordinary skill in the art from the disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. The method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into the detailed description, with each claim standing on its own as a separate embodiment of the invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of the description.

The following terms are provided solely to aid in the understanding of the invention.

As used herein and unless provided otherwise, the term "self-assembled monolayer (SAM) material" refers to molecular assemblies that form on the surfaces spontaneously by adsorption and are organized into more or less large ordered domains. SAM materials may possess a head group with a strong affinity to the substrate, a tail group and a functional end group. SAM materials are created by the chemisorption of the head groups onto the substrate from vapor or liquid phase followed by slow organization of the tail groups.

As used herein and unless provided otherwise, the term "electrical contact" refers to a contact made on an area of a conducting or a semiconducting material.

As used herein and unless provided otherwise, the term "technology node" refers to devices in semiconductor processing having a gate length at the indicated number such for example N10 refers to technology node having a gate length of 10 nm.

As used herein and unless provided otherwise, the term "STI-last" refers to planar deposition of a material on a substrate followed by patterning it to make the fin structures and filling in the space between the fin structures with a dielectric material.

As used herein and unless provided otherwise, the term "STI-first" refers to the growth of fin structures in trenches made in a dielectric material, which is provided on a substrate.

As used herein and unless provided otherwise, the term "contact resistance" refers to the contribution to the series resistance of a field effect transistor, which depends on the resistivity of the metal/semiconductor resistivity and the area through which the metal contacts the semiconductor.

As used herein and unless provided otherwise, the term "contact hole" refers to a recess made in a dielectric material overlying a patterned substrate. Contact hole exposes a part of a source region or a drain region of a FET and is filled with a contact metal fill to contact the source region or the drain region to an interconnect structure.

As used herein and unless provided otherwise, the term "having a material that has good etch selectivity with respect to another material" refers to the etch rate of the material being higher than that of the another material given under prescribed etching conditions.

As used herein and unless provided otherwise, the term "conformal" refers to being able to follow the topography of any surface.

As used herein and unless provided otherwise, the term "exposed" refers to a layer, a surface or a region that is in contact with surrounding atmosphere.

As used herein and unless provided otherwise, the term "un-exposed" refers to a layer, a surface or a region that is not in contact with the surrounding atmosphere.

As used herein and unless provided otherwise, the term "etching a material selectively to another material" implies that the material is etched without etching the another material.

As used herein and unless provided otherwise, the term "oxygen getter" refers to a material that scavenges oxygen.

As used herein and unless provided otherwise, the term "wrap-around contact" refers to an electrical contact covering a source and/or a drain region from all exposed sides. When the field effect transistor device is fin-type field effect transistor (Fin-FET), wrap around contact refers to an electrical contact covering the top and part of the sidewalls of the fin structure, which define the source and/or drain region.

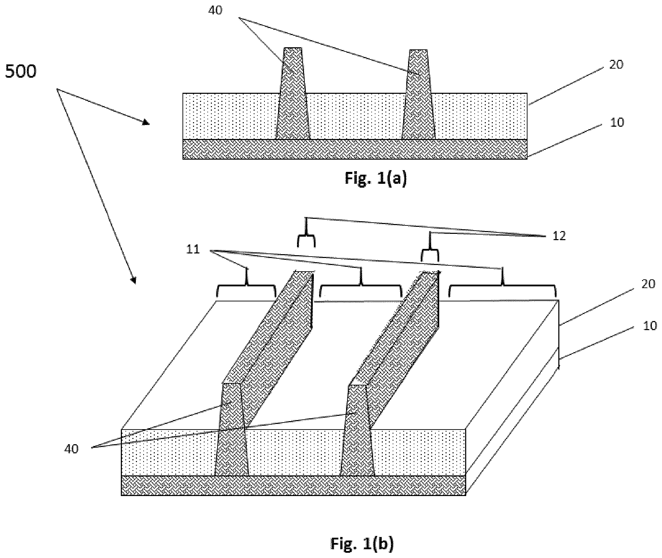

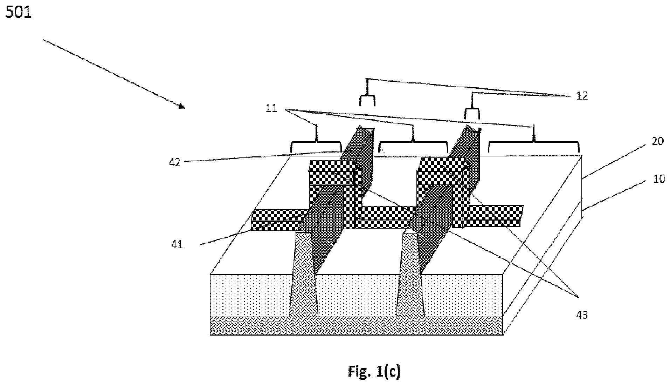

We now refer to Figure 1.

**Figure 1** shows a schematic (a) cross section (500) and (b) tilted view (501) of a patterned substrate. The patterned substrate (500, 501) comprises a semiconductor region (12) and a dielectric region (11).

The dielectric region (11) comprises a dielectric material (20), which is typically SiO₂, that is in contact with a semiconductor substrate (10). The semiconductor substrate (10) may be a Si or Ge substrate (10) such as a Si wafer or a Ge wafer. The semiconductor substrate may also be a silicon on insulator (SOI) or germanium on insulator (GeOI) substrate.

The semiconductor region (12) comprises a plurality of structures having lateral walls and a top surface that protrude from the dielectric material (20). The plurality of structures are fin structures (40). As it may be understood by a person skilled in the art, the patterned substrate as illustrated in Fig. 1 (a) and Fig. 1 (b) forms the basis for forming a finFET device comprising the plurality of fin structures (40).

The patterned substrate (500, 501)) may be manufactured by using the Shallow Trench Isolation (STI) approach as known in semiconductor manufacturing. The dielectric material (20), which is SiO₂, functions as isolation material. Either STI-last or STI-first approach may be used as known in the art to produce the patterned substrate (500, 501) such as that shown in Fig. 1 (a) or Fig. 1(b). The fin structures (40) may comprise a Group III-V compound semiconductor. The fin structures (40) may also comprise at least one element selected from the group consisting of Si and Ge.

The fin structures (40) may be doped with a dopant element at a desired doping concentration defined by the technology node in question. Doping of the fin structures leads to the formation of an n-type or p-type channel depending on the type of the dopant element. The height and width of the fin structures may be defined by the choice of the technology node in question.

The fin structures (40) may comprise a gate stack (43) covering a channel region, and spacers (not shown in the figure), which embed the gate stack on both sides. The channel region is located in between a source region (41) and a drain region (42) as shown in Fig. 1(c). The gate stack (43) may be a dummy gate stack comprising, for example, a thin layer of SiO₂ as the dummy gate dielectric (not shown in the figures)and amorphous silicon (a-Si) as the dummy gate metal.

One way of carrying out the source/drain formation module is such that the fin structures (40) in the source region (41) and the drain region (42) may be recessed followed by epitaxial regrowth. Thus, the epitaxially regrown source and drain in this fashion are typically referred to as embedded source and drain and may be formed from the same semiconductor material as that of the fin structures, such for example a Ge fin and epitaxially regrown Ge on it. The epitaxially regrown source and drain may also be formed from a different semiconductor material, such for example a Ge fin and epitaxially regrown Si_{X}Ge_{1-X} on it. Epitaxial regrowth of the source/drain proceeds until the original height of the fin structures (40) is reached. In practice, how high the epitaxial regrown source/drain will be is a free choice. For optimal connectivity into the extension region, regrowth is done typically up to the original fin height. However, depending on the type of the epitaxial regrowth being epitaxial regrowth of Si or SiGe, the shape of the epitaxial regrown part might differ due to different growth rate along different crystallographic planes. As a result, SiGe typically grows diamond shaped between gates, while the shape is more of a triangular shape for Si. In-situ doping during epitaxial regrowth or doping after epitaxial regrowth by ion implantation may be performed. The doping may be done by using a suitable dopant element such as for example by using a p-type or an n-type dopant such that it results in a highly-doped source/drain so as to minimize contact resistance. Contact resistance is already a key contributor to device performance at state-of-the art N14 technology in semiconductor industry. Lowering the contact resistivity and increasing the contact area allows for reducing the contact resistance. Typical doping concentration targeted for source/drain in technology nodes smaller than N10 in semiconductor manufacturing is at least 1x10²⁰/cm³. Typically a contact resistance value of sub le-9 Ohm.cm2 is targeted for N7 and N5 technology. This can probably only be achieved with dopant concentrations exceeding 1e21 at/cm³.

In an alternative approach to carry out source/drain formation module, epitaxial regrowth may take place directly on the fin structures (40). Thus, the epitaxially regrown source and drain in this fashion are typically referred to as raised source and drain. In-situ doping or doping after regrowth may be performed in the same way as that of embedded source and drain formation module.

The shape of the epitaxially regrown source drain regions depends on whether the epitaxial regrowth can take place freely or whether the regrowth is confined by a kind of spacer material in which case the epitaxial regrowth will only fill up the cavity created by fin recess.

The dummy gate stack (43) is replaced with the actual gate stack that comprises a high-k dielectric material, as the gate dielectric, and a gate metal. This is called high-k last replacement metal gate module (HKL-RMG) as known in the art. Typically, this HKL-RMG takes place before opening the contact holes, which reach to the source and drain region through an interlayer dielectric.

The inventors have found out that the method according to the embodiments of the present invention enables carrying out the HKL-RMG after contact hole opening and electrical contact formation therein. When the replacement is done before contact opening and electrical contact formation, alignment markers may be damaged. Alignment markers are used when consecutive lithography and etching processes are to be performed for patterning layers so that layers can be aligned in the intended way with respect to each other to end up with correct patterning. Damage to the alignment markers can further cause alignment problems for contact hole opening. It is thus, an advantage of the embodiments of the present invention that postponing the replacement until after contact hole opening and contact formation allows performing the correct alignment with respect to the a-Si dummy gate metal.

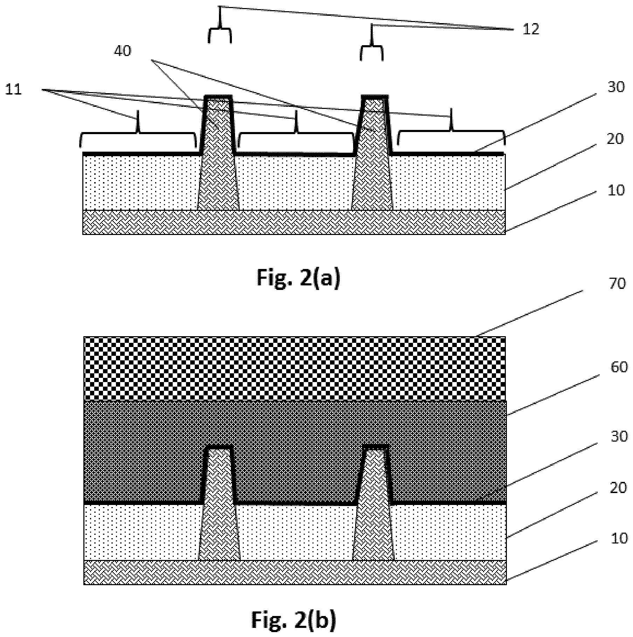

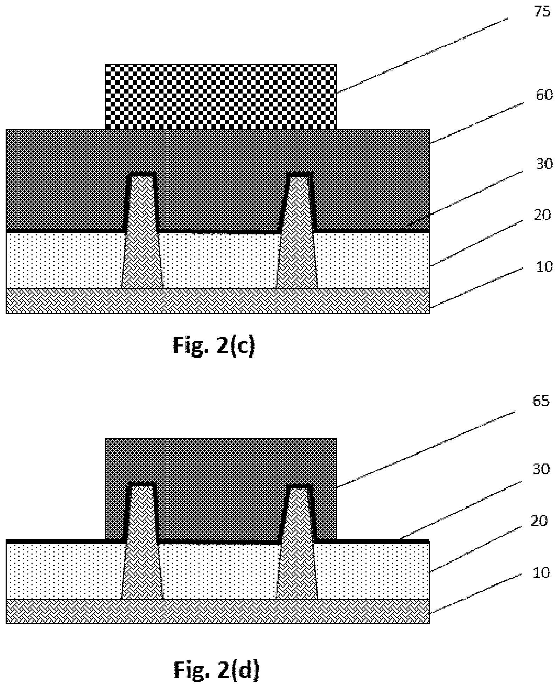

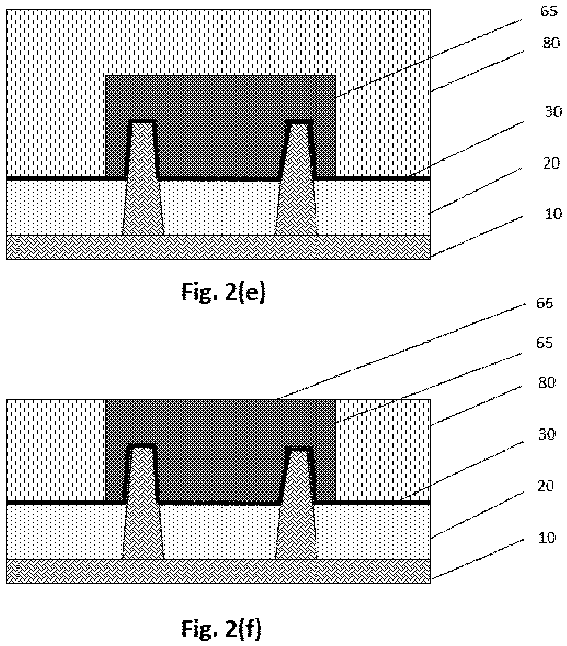

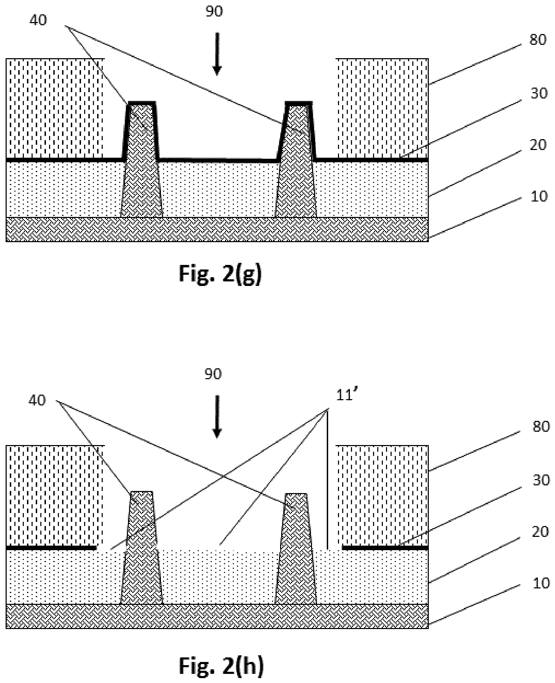

We now refer to Figure 2.

**Figure 2 (a)** to **Figure 2(h)** show schematically fabricating a semiconductor structure according to embodiments of the present invention.

As illustrated in **Fig. 2(a)**, a conformal layer of a first dielectric material (30) may be deposited directly on the patterned substrate (500, 501), thereby covering the semiconductor region (12) and the dielectric region (11).

In embodiments, the first dielectric material (30) may be a metal oxide, a silicon oxide or a silicon nitride.

In embodiments, the silicon nitride may be Si₃N₄.

In embodiments, the metal oxide may be an aluminum oxide or titanium oxide.

In preferred embodiments, the aluminum oxide may be Al₂O₃.

In preferred embodiments, the titanium oxide may be TiO₂.

In preferred embodiments, the first dielectric material may be the silicon oxide.

In yet preferred embodiments, the silicon oxide may be SiO₂.

In embodiments, the first dielectric material (30) may be deposited by using Atomic Layer Deposition (ALD), Chemical Vapor Deposition (CVD) or Low-Pressure Chemical Vapor Deposition (LP-CVD). As device scaling is on-going, it is advantageous to deposit a thin layer of the first dielectric material. Deposition of a thin layer of the first dielectric material is advantageous since filling up the small gap between dense gate structures is not desired.

In preferred embodiments, the first dielectric material (30) may, therefore, be deposited by using ALD process, since it allows for depositing a conformal and thin layer on the patterned substrate (500, 501).

In embodiments, the thickness of the first dielectric material may be in the range of 1 nm to 5 nm.

After the conformal deposition of the first dielectric material (30) on the patterned substrate (e.g. by using ALD process), a layer of a sacrificial material (60) is deposited directly on the first dielectric material (30) **(****Fig. 2(b)****).** The sacrificial material covers the surface of the patterned substrate and embeds the fin structures(40) on all sides.

In embodiments, the sacrificial material (60) may be deposited by Plasma Enhanced Chemical Vapor Deposition (PE-CVD).

In embodiments, the sacrificial material (60) may be an amorphous carbon material or an amorphous silicon material.

Both the amorphous carbon material and the amorphous silicon material are suitable to be used as the sacrificial material owing to the fact that they have good etch selectivity with respect to SiO₂ or Si₃N₄, which may be chosen as the conformal layer of the first dielectric material.

Patterning the sacrificial material (60) comprises providing a patterned photoresist layer (75) on the sacrificial material (60) **(****Fig. 2(c)****).** The sacrificial material (60) is then dry plasma etched using the patterned photoresist layer (75) as a mask. After dry plasma etching is completed, patterned photoresist layer (75) is removed **(****Fig. 2(d)****).** Patterning of the sacrificial material (60) is done such that at least a part of the semiconductor region remains covered by the patterned sacrificial material (65). Besides, dry plasma etching of the sacrificial material (60) is selective to the conformal layer of the first dielectric material (30). This selective dry plasma etching process provides an advantage that the conformal layer of the first dielectric material (30) still remains on the patterned substrate after patterning of the sacrificial material (60) is completed. An electrical contact (100) is further to be formed on this part of the semiconductor region. More specifically, patterning of the sacrificial material (60) is done such that a pattern (65) of the patterned sacrificial material that is formed corresponds to or overlaps with an area of the patterned substrate that comprises a part of the semiconductor region on which an electrical contact (100) is to be formed.

Providing a patterned photoresist layer (75) comprises depositing a photoresist layer (70) on the sacrificial material (60) **(****Fig. 2(b)**), followed by exposure of the photoresist layer by performing a lithographic patterning process. The lithographic patterning process may be deep ultra violet (DUV), extreme ultra violet (EUV),or 193 nm immersion lithography.

A layer of a second dielectric material (80) is deposited on the patterned substrate **(****Fig. 2 (e)****).** The second dielectric material (80) completely embeds the patterned sacrificial material (65) from lateral sides and from the top surface. The second dielectric material (80) may for instance be deposited by self-aligned chemical vapor deposition (SA-CVD), high density plasma chemical vapor deposition (HDP-CVD), flowable deposition or plasma enhanced atomic layer deposition (PE-ALD).

In embodiments, the second dielectric material (80) may be a silicon oxide.

In preferred embodiments, the silicon oxide may be SiO₂. The second dielectric material (80) is typically referred to as interlayer dielectric zero (ILD0).

In preferred embodiments, the sacrificial material (60) may be an amorphous silicon material. It is advantageous to use amorphous silicon as the sacrificial material (60) due to the fact that a high temperature treatment, such as above 600 °C, is preferably used in order to densify the second dielectric material (80) after deposition. If Ge or SiGe is used as the channel material for p-MOS, a lower densification temperature of 550 °C or below down to room temperature is preferably used.

Amorphous silicon is quite stable at high temperatures, such as above 600 °C, for densification of the second dielectric material (80), which is SiO₂. In case when an amorphous carbon material would be used as the sacrificial material, it risks being ashed out during SiO₂ densification which is undesirable. Hence, amorphous carbon is preferably used when the second dielectric material is densified at a temperature of 550°C or below. In embodiments, the amorphous carbon material may be an advanced patterning film (APF). The APF layer may be deposited at a temperature in the range of 400 °C to 550 °C. Thus, if the densification of the second dielectric material may be facilitated at a temperature within or lower than this given range, then APF may be used as the sacrificial material since ashing out would be avoided.

In this preferred embodiment, where amorphous silicon may be used as the sacrificial material (60), patterning of the sacrificial material comprises providing a patterned photoresist layer (75) on the sacrificial material (60) (Fig. 2(c)). The sacrificial material (60) is then dry plasma etched using the patterned photoresist layer (75) as a mask. After dry plasma etching is completed, patterned photoresist layer (75) is removed.

In alternative embodiments, where amorphous silicon may be used as the sacrificial material (60), patterning of the sacrificial material (60) may comprise providing a hard mask layer (not shown in the figures) sandwiched and in contact with the sacrificial material (60) and the photoresist layer (70). Resist masks are typically soft, thin and they shrink when subjected to an etch plasma, thus making them unreliable as a masking layer when dimensions are scaling. Therefore, it is advantageous to use the hard mask as described. After forming the patterned photoresist layer (75) by performing a lithographic process, the hard mask layer is etched by performing a dry plasma etching process. Consequently, the patterned photoresist layer is removed, thereby leaving a patterned hard mask layer on the sacrificial material (60). The patterned hard mask layer is further used as a mask for dry plasma etching of the sacrificial material (60). Following the completion of dry plasma etching, the patterned hard mask layer is removed.

According to these alternative embodiments, the hard mask layer may be a silicon oxide or a silicon nitride.

In preferred embodiments, the silicon oxide may be SiO₂.

Yet in preferred embodiments, the silicon nitride may be Si₃N₄.

The inventors have found out that depositing the conformal layer of the first dielectric material (30) directly on the patterned substrate (500, 501) according to embodiments of the present invention is advantageous. This is due to the fact that some of the deposition techniques used to deposit the layer of the second dielectric material, which is SiO₂, involve a step where the substrate is subjected to an ozone atmosphere so as to initiate the deposition of SiO₂. Typically, for example, a self-aligned chemical vapor deposition process or a flowable oxide deposition process involves ozone in the onset of deposition. This step involving ozone exposure may damage the semiconductor region, more specifically the fin structures (40), especially when the semiconductor region is made of Ge or is Ge-comprising. The damage is created due to the oxidation of the Ge or Ge comprising semiconductor region, which then becomes prone to removal in aqueous environment. Thus, presence of the conformal first dielectric material covering the surface of the semiconductor structure avoids these damages to occur.

A chemical mechanical planarization (CMP) process may be performed until a top surface (66) of the patterned sacrificial material (65) is revealed **Fig. 2 (f)****.**

Following the CMP process, the patterned sacrificial material (65) is removed completely selectively to the conformal layer of the first dielectric material (30), thereby forming a recess (90) **(****Fig. 2(g)****).** The recess (90) may be referred to as a contact hole. The recess (90) exposes at its bottom the conformal layer of the first dielectric material (30) and the recess has lateral walls comprising the second dielectric material (80). Removal of the patterned sacrificial material (65) may be done by performing a dry etch plasma process. Complete removal of the patterned sacrificial material (65) selectively to the conformal layer of the first dielectric material (30) has the advantage that the semiconductor region masked by the patterned sacrificial material (65) is not exposed to the chemistry used during the removal and therefore is still protected.

In embodiments, where amorphous carbon may be used as the sacrificial material (60), removal may be done by subjecting the patterned substrate to a dry etch plasma comprising O₂/N₂H₂.

In preferred embodiments, where amorphous silicon may be used as the sacrificial material (60), removal of the patterned sacrificial material may be done by subjecting the semiconductor structure to a dry etch plasma comprising HBr/Cl₂. Alternatively, amorphous silicon may be easily removed by a wet etching process, whereby tetra methyl ammonium hydroxide (TMAH) is used as the wet etch process liquid.

Subsequently, the exposed layer of the first dielectric material (30) at the bottom of the recess (90) is removed selectively to the semiconductor region **(****Fig. 2(h)****).** As a result of this removal, at least a part of the semiconductor region (12) is exposed.

In embodiments, the exposed part of the semiconductor region may be a part of a source region (41) or a drain region (42) of a field effect transistor (FET).

In preferred embodiments, the field effect transistor may be a fin-type field effect transistor (finFET). The finFET comprises structures having lateral walls and a top surface that protrude from the dielectric material (20) of the dielectric region (11) and these protruding structures are fin structures (40). The source region or drain region are comprised in the fin structures.

In embodiments, at the bottom of the recess (90), a part of the dielectric region (11) may also be exposed (11'). Thus, in these embodiments, at the bottom of the recess (90), the exposed part of the fin structures (40), may protrude from the dielectric material (20) of the exposed part (11') of the dielectric region (11) .

It is advantageous to remove the first dielectric material (30) selectively to the semiconductor region (12) since this allows diminishing the risk of damaging the semiconductor region.

In embodiments, removing the first dielectric material (30) selectively to the semiconductor region (12) may be done by performing a wet etching process.

In alternative embodiments, removing the first dielectric material (30) selectively to the semiconductor region (12) may be done by performing a vapor treatment process, whereby the semiconductor structure is subjected to a vapor.

It is advantageous, in embodiments of the present invention, to remove the first dielectric material (30) by performing a wet etching process or a vapor treatment process since the exposed semiconductor region is not damaged by such a process. By contrast, using dry plasma etching for removal of the first dielectric material has potential to damage the semiconductor region.

The aluminum oxide or the titanium oxide can both be removed selectively to the semiconductor region by a wet etching process, whereby an ammonia-peroxide liquid mixture (APM) is used as the wet etch process liquid.

The silicon nitride can be removed by a wet etching process, whereby hot phosphoric acid (H₃PO₄) may be used as the wet etch process liquid. However, use of hot (H₃PO₄) should be done in caution since it is a strong etchant and may thus cause damages on the substrate and lead to issues in terms of detectivity. On the other hand, in the case when a thin Si₃N₄ layer is deposited, for instance less than 5 nm, the thin Si₃N₄ layer may first be oxidized by methods known to persons skilled in the art. Subsequently, removal may be achieved by using a aqueous HF solution. Typically, a concentration of less than 1 volume % is used in order to provide low and controllable etch rate. However, this may cause damages on the substrate as well such as for example irregular etching, such as for example anisotropic etching.

The silicon oxide can be removed by a wet etching process, whereby a aqueous hydrogen fluoride (HF) is used as the wet etch process liquid. Furthermore, the silicon oxide can also be removed by performing a vapor HF treatment.

In embodiments of the present invention, it is advantageous that the first dielectric material (30) may be SiO₂, since it can be easily removed by a wet etching process, whereby an aqueous HF solution is used as the wet etch process liquid. Typically, a concentration of less than 1 % volume is used in order to provide low and controllable etch rate. In addition to being removed easily, silicon oxide is further advantageous to be used as the first dielectric material owing to the fact that it is easily deposited on the semiconductor structure.

The advantage of selective wet etching process done in order to remove the first dielectric material is such that the exposed part of the semiconductor region is undamaged.

Thus, the dopant concentration within the exposed part of the semiconductor region is kept substantially at the intended level that was achieved by doping during and/or after the source/drain formation module. This results in a finFET device with minimized contact resistance.

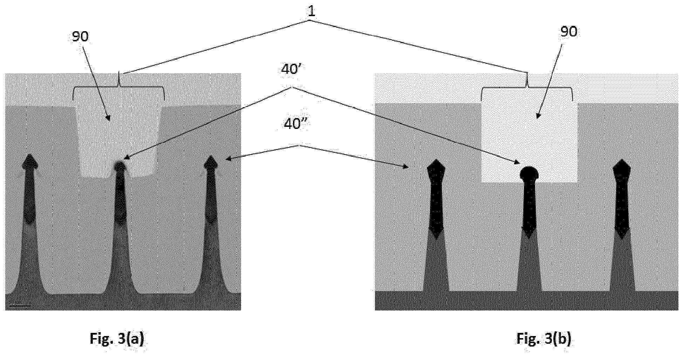

We now refer to Figure 3.

**Figure 3** shows a cross section (a) TEM image and (b) schematic representation of a cross-section of the exposed part of the semiconductor region of a semiconductor structure that is damaged after a contact opening process is done to form the contact hole (90) according to the prior art. The typical contact opening process comprises depositing the second dielectric material (80) on the patterned substrate (500, 501). A patterned photoresist layer (75) is provided on the second dielectric material (80) comprising patterned photoresist features and apertures in between these patterned photoresist features (75). A contact hole (90) is formed by dry plasma etching through the second dielectric material (80) using the patterned photoresist layer as a mask. Subsequently, patterned photoresist layer is stripped from the semiconductor structure as known to persons skilled in the art. Comparison of the profile of the fin structure (40') in the exposed part (1) of the semiconductor region (12) with that of another fin structure (40"), which is unexposed, shows that the prior (40') has a distorted profile due to the damage caused by the dry plasma etching process done in order to open the contact hole (90).

It is advantageous according to embodiments of the present invention that, contrary to the aforementioned typical contact hole formation process of the prior art, patterned photoresist features are not provided on the second dielectric material (80) in order to form the recess (90) in the second dielectric material (80) by etching through the second dielectric material (80) using the patterned photoresist features as a mask. Since usage of patterned photoresist features are avoided on the second dielectric material (80), performing the strip process after formation of the contact hole (90) becomes obsolete. Absence of the strip process after formation of the contact hole (90), in embodiments of the present invention, is advantageous due to the fact that the strip process chemistry may potentially oxidize the exposed part of the semiconductor region. The oxidized layer is susceptible to removal. Removal may then result in material loss from the exposed part of the semiconductor region and thus leading to a change in the dopant concentration from the intended level that was achieved during and/or after the source/drain formation module by doping.

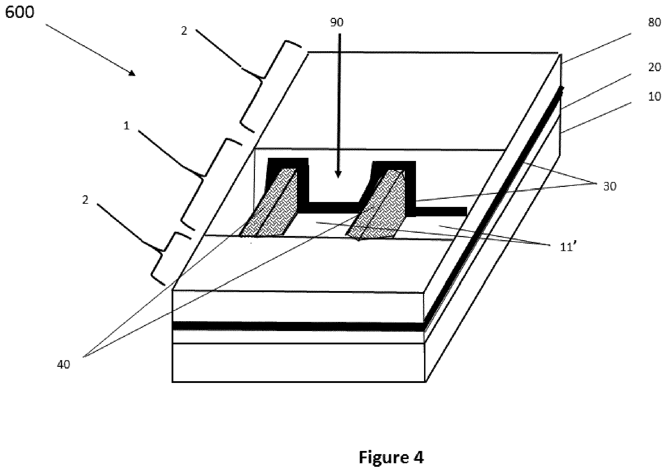

We now refer to **Figure 4** showing a tilted view of a semiconductor structure (600) fabricated according to embodiments of the present invention.

The semiconductor structure (600) comprises a patterned substrate (500, 501) that comprises a semiconductor region and a dielectric region. A layer of a second dielectric material (80) overlays the patterned substrate. The second dielectric material (80) has a recess (90) that exposes a part of the semiconductor structure (600). The exposed part (1) of the semiconductor structure (600) comprises at least a part of the semiconductor region.

In embodiments, the exposed part of the semiconductor region may be a part of a source region or a drain region of a field effect transistor (FET).

In a preferred embodiment, the field effect transistor is a fin-type field effect transistor (finFET). The finFET comprises structures having lateral walls and a top surface that protrude from the dielectric material (20) and these protruding structures are fin structures (40).

The semiconductor structure (600) further comprises a conformal layer of a first dielectric material (30) present on an un-exposed part (2) of the semiconductor structure.

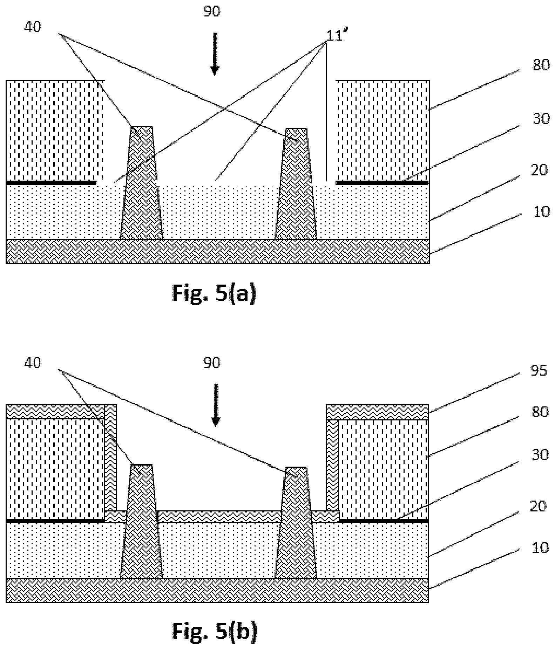

We now refer to **Fig. 5 (a)** **to** **Fig. 5(e)** showing schematically the formation of an electrical contact to a semiconductor structure according to embodiments of the present invention.

A semiconductor structure (600) such as that represented schematically in Fig. 4 is provided. The semiconductor structure (600) may be fabricated according to embodiments of the present invention.

The semiconductor structure (600) comprises a patterned substrate (500, 501) that comprises a semiconductor region and a dielectric region. A layer of a second dielectric material (80) overlays the patterned substrate. The second dielectric material (80) has a recess (90) that exposes, at its bottom, a part (1) of the patterned substrate. The exposed part (1) of the semiconductor structure (600) comprises at least a part of the semiconductor region.

In embodiments, at the bottom of the recess (90), the exposed part (1) of the semiconductor structure (600) may further comprise an exposed part (11') of the dielectric region (11).

In embodiments, the exposed part (1) of the semiconductor region may be a part of a source region or a drain region of a field effect transistor (FET).

In preferred embodiments, the field effect transistor is a fin-type field effect transistor (finFET). The finFET comprises structures having lateral walls and a top surface that protrude from the dielectric material (20) of the dielectric region (11) and these protruding structures are fin structures (40). The source region or drain region are comprised in the fin structures.

In embodiments, at the bottom of the recess (90), the exposed part (1) of the semiconductor structure (600) may comprise the exposed part (11') of the dielectric region (11), and the exposed part of the fin structures (40), where the exposed part of the fin structures (40) protrude from the exposed part (11') of the dielectric region (11). The semiconductor structure (600) further comprises a conformal layer of a first dielectric material (30) present on an un-exposed part (2) of the patterned substrate.

In embodiments, the un-exposed part (2) of the semiconductor structure (600) may comprise an un-exposed part of the source region or drain region of a first fin structure that extend longitudinally along a direction from the exposed part of the (same) source region or (same) drain region comprised in the exposed part of the patterned substrate. Alternatively, the un-exposed part (2) of the semiconductor structure (600) may comprise an un-exposed part of the source region or drain region of a second fin structure that is displaced along a direction horizontally away from the first fin structure.

It is an advantage of the semiconductor structure (600) that the profile of the exposed part of the source region or the drain region of the first fin structure may substantially be the same as that of the un-exposed part of the source region or the drain region of the first or of the second fin structure.

A self-assembled monolayer (95) material may be selectively applied on the semiconductor structure (600).

The self-assembled monolayer (95) covers conformally the semiconductor structure (600), whereby the exposed part of the semiconductor region remains uncovered **(****Fig. 5 (b)****).** Selective application of the SAM material on the second dielectric material (80) and/or the exposed part of the dielectric region (11') of the semiconductor structure (600) implies choosing a suitable SAM material such that its head group has affinity to bind to the exposed surfaces of the second dielectric material (80) and/or the dielectric region. Therefore, in embodiments of the present invention, the SAM material may be chosen such that its head group has affinity to bind to SiO₂. Such a SAM material may be chosen from a group consisting of silanes which are typically selectively grafted to the Si-OH groups on the silicon oxide, or silicon nitride surface. By selecting -CH3 hydrophobic, non-reactive groups and long alkyl chain length of the silanes, such C10-C18, and preferably C18, a dense film may be formed which will inhibit ALD nucleation making the ALD deposition of the metal to be selective on the exposed part of the semiconductor region. Normally the alkyl trichloro or trialkoxy (Methoxy or ethoxy) silanes (C10 to C18) may be deposited from the vapor phase or from organic solvents namely alcohols (i.e. ethanol, butanol, ipa propanol..) or toluene in mili molar (mM) precursor concentration as known to persons skilled in the art.

It should be noted that in order to facilitate successfully the selective deposition of SAM material (95) only on the silicon oxide or silicon nitride and not on the exposed semiconductor region, the exposed semiconductor region should be cleaned such that the surface of the exposed semiconductor region becomes oxide free. Thus, the oxide, which is usually a native oxide as referred by persons skilled in the art, should preferably be cleaned from the surface of the exposed semiconductor region prior to SAM material deposition.

In embodiments, this surface cleaning resulting in oxide removal may be done by a dry oxide removal process subsequently followed by in-situ vapor SAM deposition in the same process tool without air break.

In alternative embodiments, this surface cleaning resulting in oxide removal may be done by a wet oxide removal process subsequently followed by in-situ liquid SAM deposition in the same process tool without air break.

This in-situ SAM material deposition done either by depositing the SAM material from vapor phase or liquid phase has the advantage that the cleaned surface of the semiconductor region is not exposed to air, thus avoiding re-oxidation of the surface.

The SAM material, which is deposited selectively on the second dielectric material (80) and/or exposed part (11') of the dielectric region (11) of the semiconductor structure (600), is attached to the silicon oxide or silicon nitride through chemisorption.

It is also possible that SAM material may be deposited on the exposed part of the semiconductor region through physisorption. This physisorbed SAM layer should be removed from the exposed part of the semiconductor region before depositing the metal by ALD. Thus, a thermal annealing at a temperature lower than 400 °C may be done to remove physisorbed SAM material layer from the exposed part of the semiconductor region. Preferably, the thermal annealing may be done at a temperature in the range of 200 °C to 400 °C. It is advantageous that the temperature is chosen in the range of 200 °C to 400 °C so that only the SAM material that is attached to the exposed semiconductor region through physisorption is removed. Thermal annealing done at a temperature higher than 400 °C risks the removal of SAM material attached through chemisorption to the silicon oxide or silicon nitride, which is undesirable.

In embodiments, alternatively, extra rinsing of the semiconductor structure in organic solvents such as alcohol and/or acetone and/or water may be applied to remove physisorbed SAM material layer from the exposed part of the semiconductor region (1). This rinsing only removes the physisorbed SAM precursors, while leaving the chemisorbed SAM present on the second dielectric material (80) and/or the exposed part (11') of the dielectric region (11) of the semiconductor structure (600) unremoved.

In embodiments, the extra rinsing and the thermal annealing may both be applied to remove the_physisorbed SAM material layer from the exposed part of the semiconductor region.

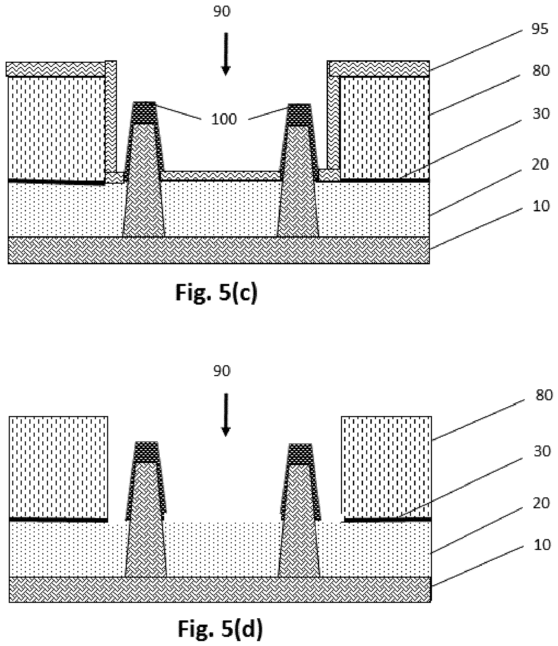

An electrical contact (100) is formed, at the bottom of the recess (90), conformally on the exposed part of the semiconductor region **(****Fig. 5 (c)****).** This exposed part of the semiconductor region is the region that remains uncovered after the SAM is selectively applied on the semiconductor structure.

It is an advantage of the present invention that an electrical contact is formed conformally on the exposed part of the semiconductor region, which is a part of a source region or a drain region of a a finFET. In order to maximize the contacting area so as to reduce the contact resistance, it is advantageous to form the electrical contact conformally everywhere on the exposed part of the semiconductor region.

Particularly, when the source region or drain region is epitaxially grown during the contact formation module, source region or drain region may be diamond shaped. Therefore, it is advantageous to form the conformal electrical contact to a depth that allows to contact the entire source region and drain region, which is highly doped. Contacting the entire source region or drain region refers to the fact that the conformal electrical contact is formed not only at the top but also laterally on the side of the source region or drain region according to embodiments of the present invention. Such kind of an electrical contact is referred to as a wrap-around contact. Contacting the highly doped source region or drain region from all sides has the advantage of enabling contact resistance minimization since the contact area is maximized.

In embodiments, formation of the electrical contact (100) comprises depositing selectively a metal on the exposed part of the semiconductor region in the bottom of the recess (90) (not shown in the figures) Following the selective deposition of the metal, a vapor-solid reaction is performed, whereby the semiconductor structure (600) is subjected to a silicon-comprising precursor gas or a germanium-comprising precursor gas. Subjecting the semiconductor structure to the silicon-comprising precursor gas or to the germanium-comprising precursor gas converts the metal to a metal silicide or a metal germanide.

Performing a vapor-solid reaction is advantageous since it allows formation of the electrical contact without consuming the substrate. The Si-comprising precursor gas or Ge-comprising precursor gas reacts with the metal and the electrical contact is formed by conversion of the metal into the metal-silicide or the metal germanide, thus keeping the exposed part of the semiconductor region intact. Since the exposed part of the semiconductor region is kept intact and not consumed during the formation of the electrical contact, the dopant concentration in this region is not reduced, thus it remains unchanged. Reduction of the dopant concentration during electrical contact formation that may occur if the metal reacts with the exposed part of the semiconductor region leading to increase in contact resistance, is undesirable.

In embodiments, the metal may be nickel. Nickel is typically used for forming electrical contacts to semiconductor structures thanks to its ability to form low resistance electrical contacts.

In embodiments, the selective deposition of the metal may be done in a first deposition tool up to a desired thickness by performing a physical vapor deposition (PVD), sputtering deposition, chemical vapor deposition (CVD) or an atomic layer deposition process (ALD). Attention is paid to the fact that the deposition temperature of the metal should be kept lower than 400 °C due to the fact that otherwise the SAM material attached to silicon oxide or silicon nitride through chemisorption risks to be partially or completely removed.

In preferred embodiments, selective deposition of the metal may be done by performing an ALD process.

In embodiments, the desired thickness of the metal may be in the range of 2 nm to 80 nm.

In preferred embodiments, the desired thickness of the metal may be in the range of 4 nm to 10 nm. It is advantageous to have the desired thickness of metal in this range due to the fact that for thicknesses higher than 10 nm, the risk exists such that the metal deposition may be non-selective; for instance it may also be deposited onto the SAM material.

In embodiments, the vapor solid reaction may be carried out in a second deposition tool at a temperature in the range of 215 °C to 350 °C. The second deposition tool may be a chemical vapor deposition (CVD) tool.

In embodiments, the vapor-solid reaction may be carried out at a temperature in the range of 215 °C to 250 °C. In these embodiments, the germanium-comprising precursor gas may be used.

In embodiments, the germanium-comprising precursor gas may comprise one or more compounds selected from the list consisting of GeH₄, Ge₂H₆, trigermane, isobutylgermane, tetramethylgermane and halides of germanium, such as for example GeCl₄, GeF₂ or GeBr₂.

In preferred embodiments, the temperature may be 225 °C and GeH₄ may be used as the Ge-comprising precursor gas. It is an advantage to use GeH₄ since it is the simplest Ge-comprising precursor gas. The electrical contact formed is a Ge-comprising alloy. The Ge comprising alloy may be a mono-nickel-germanide (NiGe) .

In embodiments, the Ge-comprising precursor gas may be diluted with H₂. The diluted Ge-comprising precursor gas may be provided into the second deposition chamber in the presence of a carrier gas.

In embodiments, the carrier gas may be an inert gas. Ar, He or N₂ may be used as carrier gas. The purpose of using carrier gas is to regulate the partial pressure of Ge-comprising precursor gas. The carrier gas is, preferably, N₂.

In embodiments, the flow rate of Ge-comprising precursor gas may be in the range of 100 sccm to 4000 sccm. Pressure of the second deposition tool may be in the range of 1.0 Torr to 6.0 Torr. Exposure time to Ge-comprising precursor gas may be in the range of 15 seconds to 300 seconds.

In alternative embodiments, the vapor-solid reaction may be carried out at a temperature in the range of 225 °C to 350 °C. In these alternative embodiments, the silicon-comprising precursor gas may be used.

In embodiments, the silicon comprising precursor gas may be halides of Si (SiCl₄, SiBr₄, SiCl₂H₂), tetraethyl orthosilicate (TEOS), hexamethyldisiloxane (HMDSO), tetraethylsilane, pentamethylsilane, hexamethyldisilane, or tetramethylsilane, methylsilane.

In preferred embodiments, the silicon-comprising precursor gas may be SiH₄. The electrical contact formed is a Si comprising alloy. The Si comprising alloy may be a mono-nickel-silicide (NiSi).

In embodiments, the Si-comprising precursor gas may be diluted with H₂. The diluted Si-comprising precursor gas may be provided into the second deposition chamber in the presence of a carrier gas.

In embodiments where the Si-comprising precursor gas may be used, the carrier gas may be an inert gas. Ar, He or N₂ may be used as carrier gas.

In embodiments, the flow rate of Si-comprising precursor gas may be in the range of 100 sccm to 900 sccm. Pressure of the second deposition tool may be in the range of 1.0 Torr to 6.0 Torr. Exposure time to Si-comprising precursor gas may be in the range of 15 seconds to 300 seconds.

In embodiments, formation of the electrical contact (100) may comprise selectively depositing a layer stack on the exposed part of the semiconductor region by using an ALD process (not shown in the figures). The layer stack may comprise a metal in contact with the exposed part (1) of the semiconductor region in the bottom of the recess (90) and a metal nitride layer on and in contact with the metal.

In embodiments, the thickness of the metal may be in the range of 1 nm to 5 nm

In embodiments, the thickness of the metal nitride may be in the range of 1 nm to 5 nm

In preferred embodiments, the metal may be Ti. Using Ti is advantageous since it is a good oxygen getter allowing to avoid residual oxide at the interface between semiconductor region and the metal itself. Presence of residual oxide can adversely influence the contact resistance. Furthermore, Ti advantageously covers the source region or drain region completely.

In preferred embodiments, the metal nitride may be TiN. Using TiN is advantageous since it forms a good interface between the contact metal and Ti. TiN may be deposited by ALD or by physical vapor deposition (PVD). When deposited by ALD, TiN is stoichiometric. When deposited by PVD, Ti/N ratio can be tuned, however the layer is typically Ti-rich.

Following the formation of the conformal electrical contact (100), the self-assembled monolayer (95) material is removed selectively from the semiconductor structure (600) **((****Fig. 5 (d)****).** Removing the SAM material (95) selectively may be done by annealing at a temperature higher than 400C, or by applying plasma and/or UV ozone treatments and/or dipping in wet etching/oxidizing chemistry such as tetramethyl ammonium hydroxide (TMAH), hydrogen fluoride (HF), piranha solution, which is a mixture of hydrogen sulfide and hydrogen peroxide (H2SO4/H2O2).

A contact metal (110) is provided on the semiconductor structure (600) filling in the recess (90). The contact metal may also be referred to as a contact metal fill in the art. Typically, the contact metal (110) is tungsten (W) and it is deposited by an ALD or a CVD process.

Alternatively, the contact metal (110) may be a Ni-comprising contact metal fill or a Co-comprising contact metal fill. The Ni-comprising contact metal fill or the Co-comprising contact metal fill may be provided by performing an electroplating process.

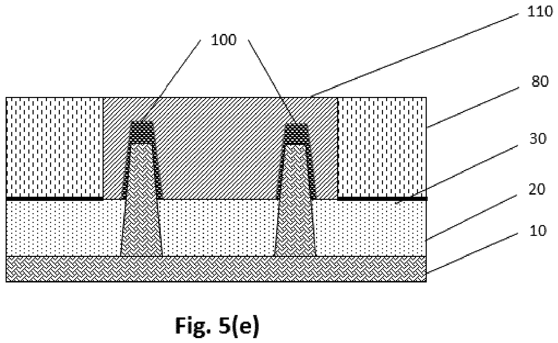

A CMP process is performed until a top surface of the second dielectric material (80) is revealed. The CMP process removes excess contact metal (110) overlaying the semiconductor structure (600), thereby resulting in a flat surface **(****Fig. 5 (e)****).**

## Claims

1. A method for forming, selectively, an electrical contact to a semiconductor structure, the method comprising:
- providing a patterned substrate (500, 501) for forming a FinFET device comprising, on a main surface:
∘ a dielectric region (11) comprising a dielectric material (20) in contact with a semiconductor substrate (10), and;
∘ a semiconductor region (12) comprising a plurality of fin structures (40), protruding from the dielectric material (20),
- depositing, directly on the patterned substrate (500, 501), a conformal layer of a first dielectric material (30) thereby covering the semiconductor region (12) and the dielectric region (11),
- depositing a layer of a sacrificial material (60) on the conformal layer of the first dielectric material (30),
- patterning the sacrificial material (60) whereby at least a part of the semiconductor region remains covered by the patterned sacrificial material (65),
- depositing a layer of a second dielectric material (80) on the patterned substrate, thereby completely covering the patterned sacrificial material (65),
- removing an excess portion of the second dielectric material (80) by performing a surface flattening process, thereby exposing a top surface (66) of the patterned sacrificial material (65),
- forming a recess (90) in the second dielectric material (80) by completely removing the patterned sacrificial material (65) selectively to the conformal layer, thereby exposing, at its bottom, the conformal layer of the first dielectric material (30), and;
- removing the exposed conformal layer of the first dielectric material (30) selectively to the semiconductor region, thereby, at least exposing the part of the semiconductor region,
- applying selectively a self-assembled monolayer (95) on the second dielectric material (80) and on an exposed part (11') of the dielectric region of the (11) semiconductor structure, whereby, the exposed part of the semiconductor region remains uncovered,
- forming, selectively, the electrical contact (100) on the exposed part of the semiconductor region, at the bottom of the recess (90), and;
- selectively removing the self-assembled monolayer (95).

2. The method according to claim 1, wherein removing the exposed conformal layer of the first dielectric material (30) selectively to the semiconductor region is done by performing a wet etching process.

3. The method according to any of the preceding claims, wherein the sacrificial material (60) is an amorphous carbon material or an amorphous silicon material.

4. The method according to any of preceding claims, wherein the depositing of the conformal layer of the first dielectric material (30) is done by Atomic Layer Deposition (ALD).

5. The method according to any of the preceding claims, wherein the exposed part of the semiconductor region is a part of a source region (41;42) or of a drain region (42;41) of a field effect transistor.

6. The method according to claim 1, wherein forming, selectively, the electrical contact comprises:
- depositing selectively a metal on the exposed part of the semiconductor region at the bottom of the recess, and;
- performing a vapor-solid reaction, whereby the semiconductor structure is subjected to a silicon-comprising precursor gas or a germanium-comprising precursor gas, thereby converting the metal to respectively a metal silicide or a metal germanide.

7. The method according to claim 1, wherein forming, selectively, the electrical contact (100) comprises depositing a layer stack by using an Atomic Layer Deposition (ALD) process, wherein the layer stack comprises a metal layer in contact with the exposed part of the semiconductor region (12) at the bottom of the recess (90) and a metal nitride layer on and in contact with the metal layer.

8. The method according to claim 1 to 7, wherein the electrical contact (100) is a wrap-around contact.

## Patentansprüche

1. Verfahren zum selektiven Bilden eines elektrischen Kontakts zu einer Halbleiterstruktur, wobei das Verfahren umfasst:
- Bereitstellen eines strukturierten Substrats (500, 501), um ein FinFET-Bauelement zu bilden, das auf einer Hauptfläche umfasst:
-- einen dielektrischen Bereich (11), der ein dielektrisches Material (20) in Kontakt mit einem Halbleitersubstrat (10) umfasst; und
-- einen Halbleiterbereich (12), der eine Vielzahl von Grat-Strukturen (40) umfasst, die aus dem dielektrischen Material (20) herausragen,
- Abscheiden einer konformen Schicht eines ersten dielektrischen Materials (30) direkt auf dem strukturierten Substrat (500, 501), wodurch der Halbleiterbereich (12) und der dielektrische Bereich (11) bedeckt werden,
- Abscheiden einer Schicht eines Opfermaterials (60) auf der konformen Schicht des ersten dielektrischen Materials (30),
- Strukturieren des Opfermaterials (60), wodurch mindestens ein Teil des Halbleiterbereichs von dem strukturierten Opfermaterial (65) bedeckt bleibt,
- Abscheiden einer Schicht eines zweiten dielektrischen Materials (80) auf dem strukturierten Substrat, wodurch das strukturierte Opfermaterial (65) vollständig bedeckt wird,
- Abtragen eines Überstands des zweiten dielektrischen Materials (80) durch Durchführen eines Flächenglättungsvorgangs, wodurch eine obere Fläche (66) des strukturierten Opfermaterials (65) freigelegt wird,
- Bilden einer Vertiefung (90) in dem zweiten dielektrischen Material (80) durch vollständiges Abtragen des strukturierten Opfermaterials (65) selektiv zur konformen Schicht, wodurch an ihrem Boden die konforme Schicht des ersten dielektrischen Materials (30) freigelegt wird; und
- Abtragen der freiliegenden konformen Schicht des ersten dielektrischen Materials (30) selektiv zum Halbleiterbereich, wodurch mindestens der Teil des Halbleiterbereichs freigelegt wird,
- selektives Aufbringen einer selbstorganisierenden Monoschicht (95) auf das zweite dielektrische Material (80) und auf einen freiliegenden Teil (11') des dielektrischen Bereichs der (11) Halbleiterstruktur, wodurch der freiliegende Teil des Halbleiterbereichs frei bleibt,
- selektives Bilden des elektrischen Kontakts (100) auf dem freiliegenden Teil des Halbleiterbereichs am Boden der Vertiefung (90); und
- selektives Abtragen der selbstorganisierenden Monoschicht (95).

2. Verfahren nach Anspruch 1, wobei das Abtragen der freiliegenden konformen Schicht des ersten dielektrischen Materials (30) selektiv zum Halbleiterbereich durch Durchführen eines Nassätzvorgangs erfolgt.

3. Verfahren nach einem der vorstehenden Ansprüche, wobei es sich beim Opfermaterial (60) um ein amorphes Kohlenstoffmaterial oder ein amorphes Siliziummaterial handelt.

4. Verfahren nach einem der vorstehenden Ansprüche, wobei das Abscheiden der konformen Schicht des ersten dielektrischen Materials (30) durch Atomlagenabscheidung (ALD) erfolgt.

5. Verfahren nach einem der vorstehenden Ansprüche, wobei es sich beim freiliegenden Teil des Halbleiterbereichs um einen Teil eines Quellenbereichs (41; 42) oder eines Senkenbereichs (42; 41) eines Feldeffekttransistors handelt.

6. Verfahren nach Anspruch 1, wobei das selektive Bilden des elektrischen Kontakts umfasst:
- selektives Abscheiden eines Metalls auf dem freiliegenden Teil des Halbleiterbereichs am Boden der Vertiefung; und
- Durchführen einer Dampf-Feststoff-Reaktion, wobei die Halbleiterstruktur einem siliziumhaltigen Vorläufergas oder einem germaniumhaltigen Vorläufergas ausgesetzt wird, wodurch das Metall in ein Metallsilizid bzw. ein Metallgermanid umgewandelt wird.

7. Verfahren nach Anspruch 1, wobei das selektive Bilden des elektrischen Kontakts (100) das Abscheiden eines Schichtenstapels unter Verwendung eines Atomlagenabscheide- (ALD) Vorgangs umfasst, wobei der Schichtenstapel eine Metallschicht in Kontakt mit dem freiliegenden Teil des Halbleiterbereichs (12) am Boden der Vertiefung (90), und eine Metallnitridschicht auf, und in Kontakt mit der Metallschicht umfasst.

8. Verfahren nach Anspruch 1 bis 7, wobei es sich bei dem elektrischen Kontakt (100) um einen Rundumkontakt handelt.

## Revendications

1. Procédé pour former, de manière sélective, un contact électrique avec une structure semi-conductrice, le procédé comprenant :
- la fourniture d'un substrat à motifs (500, 501) pour former un dispositif FinFET comprenant, sur une surface principale :
o une région diélectrique (11) comprenant un matériau diélectrique (20) en contact avec un substrat semi-conducteur (10) et ;
o une région semi-conductrice (12) comprenant une pluralité de structures d'ailettes (40), faisant saillie depuis le matériau diélectrique (20),
- le dépôt, directement sur le substrat à motifs (500, 501), d'une couche conforme d'un premier matériau diélectrique (30), ce qui permet de recouvrir la région semi-conductrice (12) et la région diélectrique (11),
- le dépôt d'une couche d'un matériau sacrificiel (60) sur la couche conforme du premier matériau diélectrique (30),
- la formation de motifs sur le matériau sacrificiel (60), grâce à quoi au moins une partie de la région semi-conductrice reste recouverte par le matériau sacrificiel à motifs (65),
- le dépôt d'une couche d'un second matériau diélectrique (80) sur le substrat à motifs, ce qui permet de recouvrir complètement le matériau sacrificiel à motifs (65),
- le retrait d'une partie en excès du second matériau diélectrique (80) en effectuant un traitement d'aplatissement de surface, ce qui permet d'exposer une surface supérieure (66) du matériau sacrificiel à motifs (65),
- la formation d'un évidement (90) dans le second matériau diélectrique (80) en enlevant complètement le matériau sacrificiel à motifs (65) de manière sélective de la couche conforme, ce qui permet d'exposer, au niveau de son fond, la couche conforme du premier matériau diélectrique (30) et ;
- le retrait de la couche conforme exposée du premier matériau diélectrique (30) de manière sélective de la région semi-conductrice, ce qui permet, au moins, d'exposer la partie de la région semi-conductrice,
- l'application de manière sélective d'une monocouche auto-assemblée (95) sur le second matériau diélectrique (80) et sur une partie exposée (11') de la région diélectrique de la (11) structure semi-conductrice, grâce à quoi la partie exposée de la région semi-conductrice reste découverte,
- la formation de manière sélective du contact électrique (100) sur la partie exposée de la région semi-conductrice au fond de l'évidement (90) et ;
- le retrait de manière sélective de la monocouche auto-assemblée (95).

2. Procédé selon la revendication 1, dans lequel le retrait de la couche conforme exposée du premier matériau diélectrique (30) de manière sélective de la région semi-conductrice est réalisé en effectuant un processus de gravure humide.

3. Procédé selon l'une quelconque des revendications précédentes, dans lequel le matériau sacrificiel (60) est un matériau de carbone amorphe ou un matériau de silicium amorphe.

4. Procédé selon l'une quelconque des revendications précédentes, dans lequel le dépôt de la couche conforme du premier matériau diélectrique (30) est réalisé par un dépôt de couche atomique (ALD).

5. Procédé selon l'une quelconque des revendications précédentes, dans lequel la partie exposée de la région semi-conductrice est une partie d'une région source (41;42) ou d'une région de drain (42;41) d'un transistor à effet de champ.

6. Procédé selon la revendication 1, dans lequel la formation, de manière sélective, du contact électrique comprend :
- le dépôt de manière sélective d'un métal sur la partie exposée de la région semi-conductrice au fond de l'évidement et ;
- la réalisation d'une réaction vapeur-solide, grâce à quoi la structure semi-conductrice est soumise à un gaz précurseur comprenant du silicium ou à un gaz précurseur comprenant du germanium, ce qui permet de convertir le métal respectivement en un siliciure métallique ou un germaniure métallique.

7. Procédé selon la revendication 1, dans lequel la formation, de manière sélective, du contact électrique (100) comprend le dépôt d'un empilement de couches en utilisant un processus de dépôt de couche atomique (ALD), dans lequel l'empilement de couches comprend une couche de métal en contact avec la partie exposée de la région semi-conductrice (12) au fond de l'évidement (90) et une couche de nitrure métallique sur la couche métallique et en contact avec celle-ci.

8. Procédé selon la revendication 1 à 7, dans lequel le contact électrique (100) est un contact enveloppant.
